Europäisches Patentamt

European Patent Office

Office européen des brevets

(19)

(11) Veröffentlichungsnummer: **0 431 214 A1**

## (12) EUROPÄISCHE PATENTANMELDUNG

(21) Anmeldenummer: 89122683.9

(22) Anmeldetag: 08.12.89

(51) Int. Cl.5: **H03M 3/02**

(43) Veröffentlichungstag der Anmeldung:
**12.06.91 Patentblatt 91/24**

(84) Benannte Vertragsstaaten:
**AT BE CH DE ES FR GB GR IT LI LU NL SE**

(71) Anmelder: **Siemens Aktiengesellschaft
Wittelsbacherplatz 2
W-8000 München 2(DE)**

(72) Erfinder: **Gazsi, Lajos, Dr.
Faunastrasse 23
W-4000 Düsseldorf(DE)**

(54) **Analog-Digital-Wandleranordnung.**

(57) Analog-Digital-Wandleranordnung mit i Sigma-Delta-Modulatoren (M0,...M5), die durch ein analoges Eingangssignal (E) angesteuert werden und die digitale Ausgangssignale (A) mit bestimmter Abtastrate abgeben, mit i Verstärkern (A1,...A5), die den Sigma-Delta-Modulatoren jeweils vorgeschaltet sind, mit i ersten Abtastratenreduziereinrichtungen (R0,...R5), die den Sigmal-Delta-Modulatoren jeweils nachgeschaltet sind, mit i Dämpfungsgliedern (D1...D3), die den Abtastratenreduziereinrichtungen jeweils nach-geschaltet sind und deren Dämpfungsfaktoren jeweils gleich dem Kehrwert des im Eingangskreis des entsprechenden Sigma-Delta-Modulators auftretenden Verstärkungsfaktors ist, mit einer Prioritätslogik (PL), die nach Auswertung der Signale der Abtastratenreduziereinrichtungen eines der Signale zum Ausgang durchschaltet, und mit einer zweiten Abtastratenreduziereinrichtung (RA), die der Prioritätslogik nachgeschaltet ist.

## FIG 1

EP 0 431 214 A1

## ANALOG-DIGITAL-WANDLERANORDNUNG

Die Erfindung betrifft eine Analog-Digital-Wandleranordnung.

Kurze Wandlungszeiten einerseits und hohe Auflösung andererseits sind bei der Realisierung von Analog-Digital-Wandlern zwei nur schwer zu vereinbarende Forderungen. Wandler mit hoher Auflösung, wie beispielsweise nach dem Zählverfahren arbeitende Wandler, haben meist relativ lange Wandlungszeiten, während Wandler mit sehr kurzen Wandlungszeiten, wie beispielsweise Wandler nach dem Parallelverfahren, in der erzielbaren Auflösung dadurch beschränkt werden, daß der notwendige Schaltungsaufwand in etwa exponentionell mit der Ausgangswortlänge ansteigt. Daneben bieten sich verschiedene Wandler, wie z.B. Wandler nach dem Wägeverfahren oder dem erweiterten Parallelverfahren, als praktikable Lösungen an, die jedoch lediglich Kompromisse zwischen den beiden oben aufgezeigten Extremen darstellen.

Aus der DE-PS 33 37 041 ist eine Schaltungsvorrichtung zur Digitalisierung analoger Signale mit mehreren Analog-Digital-Wandlern bekannt, denen Verstärker vorgeschaltet sind und die über eine Prioritätslogik zum Ausgang durchschaltbar sind. Als Analog-Digital-Wandler finden dabei Wandler nach dem Parallelverfahren Anwendung. Damit wird eine hohe Wandelrate, ein großer Dynamikbereich und eine hohe Auflösung erreicht.

Eine weitere Alternative sind Analog-Digital-Wandler mit Überabtastung und Rauschfilterung. Dabei wird mit einer hohen Abtastfrequenz, also kurzer Wandlungszeit, statt mit hoher Auflösung gearbeitet und in einem nachfolgenden digitalen Filter aus dem hochfrequenten Signal geringer Auflösung ein niederfrequentes Signal hoher Auflösung gewonnen. Ein wesentlicher Vorteil liegt nun darin, daß bei der Realisierung von Wandlern mit Überabtastung und Rauschfilterung im Gegensatz zu den obengenannten Wandlertypen keine aufwendigen Abgleich- und Korrekturmaßnahmen notwendig sind, da der Wandler selbst aufgrund seiner geringen Auflösung, die in vielen Fällen lediglich ein Bit beträgt, und daß nachgeschaltete Rauschfilter aufgrund seiner Realisierung in Digitaltechnik nur geringe bzw. keine Empfindlichkeit gegenüber Fertigungstoleranzen aufweist.

Ein Analog-Digital-Wandler mit Überabtastung und Rauschfilterung ist beispielsweise durch einen Sigma-Delta-Modulator gegeben, dem eine Abtastratenreduziereinrichtung nachgeschaltet ist. Analog-Digital-Wandler mit Überabtastung und Rauschfilterung sind beispielsweise aus Stuart K. Tewksbury, Robert W. Hallock, Oversampled, linear predictive and noice-shaping Coders of Order N 1, IEEE Transactions on Circuits and Systems, Vol.

CAS-25, NO. 7, Juli 1978, Seite 436 ff., bekannt. Der Aufbau von Abtastratenreduziereinrichtungen ist unter anderem aus Wolfgang Heß, Digitale Filter, 1. Auflage 1989, Seite 277 ff. beschrieben. Ein üblicher Sigma-Delta-Modulator besteht z.B. aus k analogen Integrierern ( = Sigma-Delta-Modulator k-ter Ordnung) in Reihe und einem nachgeschalteten Analog-Digital-Wandler, dessen digitales Ausgangssignal durch einen Digital-Analog-Wandler wiederum in ein analoges Ausgangssignal umgesetzt wird. Dieses analoge Ausgangssignal wird dann jeweils dem Eingangssignal jedes analogen Integrierers hinzuaddiert. Das digitale Ausgangssignal wird einem Rauschfilter, das beispielsweise aus k in Reihe geschalteten digitalen Integrierern besteht, zugeführt, dem eine Abtastratenreduziereinrichtung folgt. In der Abtastratenreduziereinreichung wird das Signal, dessen Abtastfrequenz reduziert werden soll, zunächst mit einem Tiefpaß bandbegrenzt. Im Anschluß daran wird die Abtastfrequenz durch Weglassen von n-1 Abtastwerten auf 1/n erniedrigt, wobei die Grenzfrequenz des Tiefpasses größer oder gleich der doppelten um 1/n erniedrigten Abtastfrequenz ist. Der schaltungstechnische Aufwand läßt sich verringern, indem beispielsweise ein 1-Bit-Analog-Digital-Wandler, also ein Komparator, verwendet wird und somit der Digital-Analog-Wandler durch eine Leitung zu ersetzen ist.

Eine Anwendung des aus der DE-PS 33 37 041 bekannten Prinzips in Verbindng mit Sigma-Delta-Modulatoren zur Erhöhung der Auflösung ist allerdings nicht ohne weiteres möglich. Probleme bereitet vor allem die Plazierung der Prioritätslogik. Ein Anschließen der Prioritätslogik direkt an die Ausgänge der Sigma-Delta-Modulatoren ist nicht möglich, da hier das jeweilige Ausgangssignal nur in differenzieller Form vorliegt, so daß eine Aussage darüber, ob das Ausgangssignal die Bereichsgrenzen des jeweiligen Sigma-Delta-Modulators überschreitet, nicht direkt getroffen werden kann. Ist dagegen die Prioritätslogik jeweils den Abtastratenreduziereinrichtungen nachgeschaltet, so erfolgt aufgrund der Signalverzögerung durch die Tiefpässe der Abtastratenreduziereinrichtungen die Auswertung durch die Prioritätslogik ebenfalls verzögert. Dadurch werden Bereichsüberschreitungen erst später erkannt, was dann beispielsweise zu Signalverzerrungen oder einem ungünstigen Signal-Rauschverhältnis führen kann.

Aufgabe der Erfindung ist es daher, eine Analog-Digital-Wandleranordnung mit mehreren Sigma-Delta-Modulatoren, denen Verstärker vorgeschaltet sind, anzugeben, die diese Nachteile nicht aufweist.

Diese Aufgabe wird bei einer Analog-Digital-Wandleranordnung der in Rede stehenden Art durch die Merkmale des Patentanspruches 1 gelöst. Ausgestaltungen und Weiterbildungen des Erfindungsgedankens sind Gegenstand von Unteransprüchen.

Vorteile der Erfindung sind die wesentlich kürzere Verzögerungszeit und der geringere schaltungstechnische Aufwand.

Die Erfindung wird nachfolgend anhand der in den FIG der Zeichnung dargestellten Ausführungsbeispiele näher erläutert. Dabei sind gleiche Elemente mit gleichen Bezugszeichen versehen.

Es zeigt:

FIG 1 eine erste prinzipielle Ausführungsform einer erfindungsgemäßen Analog-Digital-Wandleranordnung;

FIG 2 eine zweite prinzipielle Ausführungsform einer erfindungsgemäßen Analog-Digital-Wandleranordnung und

FIG 3 eine Ausführungsform einer erfindungsgemäßen Analog-Digital-Wandleranordnung mit zwei Sigma-Delta-Modulatoren.

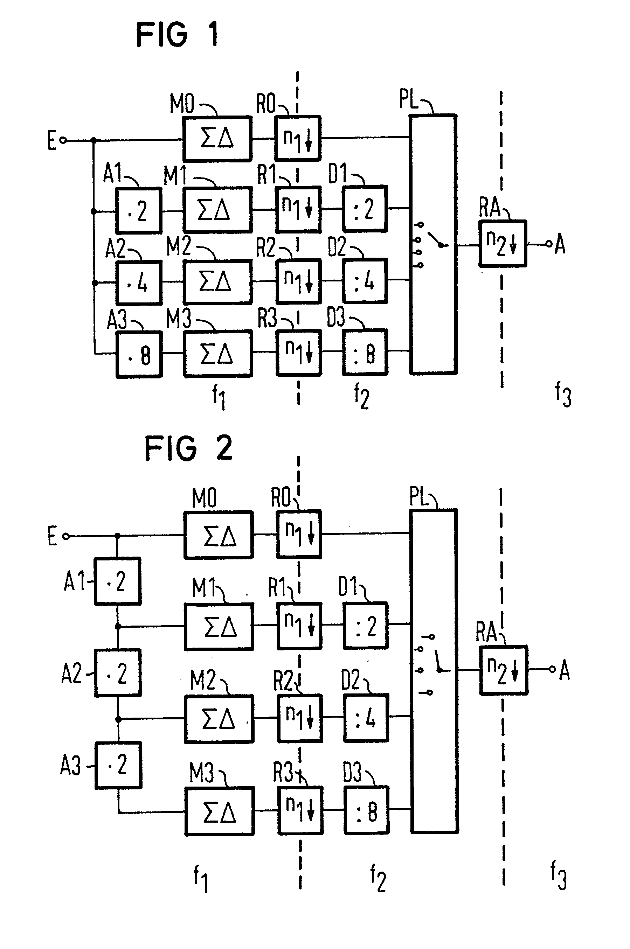

Die Ausführungsbeispiels gemäß FIG 1 und FIG 2 umfassen jeweils vier Sigma-Delta-Modulatoren M0...M3, die durch ein analoges Eingangssignal E angesteuert werden und die digitale Ausgangssignale mit gegebener Abtastrate $f_1$ abgeben. Den Sigma-Delta-Modulatoren M0...M3 sind jeweils Abtastratenreduziereinrichtungen R0...R3 nachgeschaltet, die die Ausgangssignale der jweiligen Sigma-Delta-Modulatoren M0...M3 tiefpaßfiltern und anschließend die Abtastrate $f_1$ auf $f_1/n_1$ erniedrigen. An den Ausgängen der Abtastratenreduziereinrichtungen R0...R3 liegen somit digitale Signale mit einer Abtastrate $f_2 = f_1/n_1$ an. Die Tiefpaßfilterung der Abtastratenreduziereinrichtungen R0...R3 wirkt dabei gleichzeitig als Bandbegrenzung für die Abtastratenreduziereinrichtung und als Rauschfilter für die Sigma-Delta-Modulatoren. Den Sigma-Delta-Modulatoren M1,M2,M3 sind jeweils Verstärker A1,A2,A3 vorgeschaltet. Den Abtastratenreduziereinrichtungen R1,R2,R3 folgen digitale Dämpfungsglieder D1,D2,D3, deren Dämpfungen gleich den Gesamtverstärkungen der den entsprechenden Sigma-Delta-Modulatoren M1,M2,M3 vorausgehenden Verstärkern A1,A2,A3 sind. Die Ausgänge der Dämpfungsglieder D1,D2,D3 sowie der Ausgang der Abtastratenreduziereinrichtung R0 sind mit einer Prioritätslogik PL verbunden, an deren Ausgang eine weitere Abtastratenreduziereinrichtung RA angeschlossen ist. Die Abtastratenreduziereinrichtung RA erniedrigt die Abtastrate $f_2$ des Ausgangssignals der Prioritätslogik PL auf $f_2/n_2$, so daß das Ausgangssignal A der Analog-Digital-Wandleranordnung eine Abtastrate $f_3 = f_2/n_2$ aufweist.

In dem Ausführungsbeispiel nach FIG 1 sind die Verstärker A1,A2,A3 sowie der Sigma-Delta-Modulator M0 eingangsseitig parallelgeschaltet, während in dem Ausführungsbeispiel nach FIG 2 die Verstärker A1,A2,A3 in Reihe geschaltet sind, d.h. der Verstärker A1 liegt eingangsseitig parallel zu dem Sigma-Delta-Modulator M0, der Verstärker A2 ist an den Ausgang des Verstärkers A1 und der Verstärker A3 an den Ausgang des Verstärkers A2 angeschlossen. Die Verstärkungen sind in beiden Fällen so gewählt, daß die Signale an den Eingängen der Sigma-Delta-Modulatoren M0...M3 um einen Faktor, der gleich einer Potenz von 2 ist, gegenüber dem Eingangssignal E verstärkt werden. Dies ist deshalb vorteilhaft, da die entsprechenden digitalen Dämpfungsglieder D1,D2,D3 nur Schiebeoperationen durchzuführen haben, die nur einen geringen Schaltungsaufwand erfordern. Daraus folgt, daß die Verstärker A1,A2,A3 gemäß dem Ausführungsbeispiel nach FIG 1 die Verstärkungen 2,4,8 und gemäß dem Ausführungsbeispiel nach FIG 2 Verstärkungen von jeweils 2 aufweisen. Weiterhin resultiert daraus, daß sich für einen dem Sigma-Delta-Modulator M0 vorgeschalteten Verstärker bzw. für ein der Abtastratenreduziereinrichtung R0 nachgeschaltetes Dämpfungsglied eine Verstärkung bzw. eine Dämpfung gleich 1 ergibt, wodurch diese durch Leitungsbrücken ersetzt werden können.

Die Prioritätslogik PL wählt fortlaufend nach Auswertung der Signalamplitude jedes Sigma-Delta-Modulatorzweiges den Zweig aus, der innerhalb seines gegebenen optimalen Arbeitsbereiches liegt und schaltet diesen zum Ausgang durch. Der optimale Arbeitsbereich liegt zwischen dem Übersteuerungsbereich und dem Bereich mit geringer Auflösung und starker Geräuschüberlagerung. Um ein Übersteuern durch kurze Impulse möglichst zu vermeiden, wird die Umschaltschwelle bevorzugt um einen gewissen Faktor unter die Bereichsgrenze gelegt.

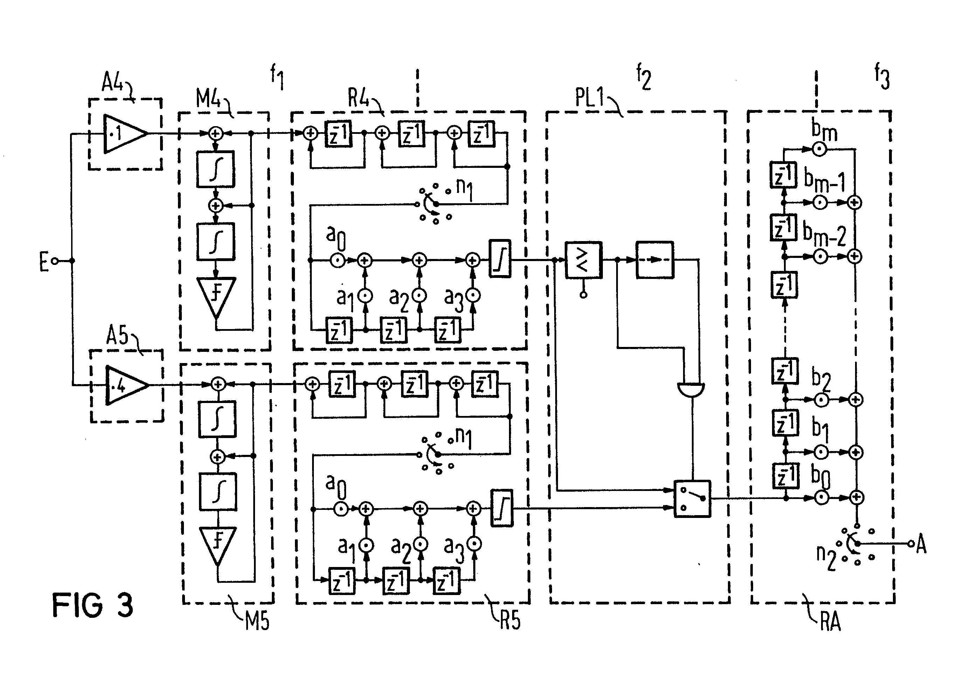

Bei dem Ausführungsbeispiel nach FIG 3 ist das analoge Eingangssignal E zum einen an den Eingang eines Verstärkers A4 und zum anderen an den Eingang eines Verstärkers A5 gelegt. Der Verstärker A4 hat eine Verstärkung von 1 und dient als Pufferverstärker. Der Verstärker A5 hat eine Verstärkung von 4 und dient zur Verschiebung des Arbeitsbereiches eines ihm nachgeschalteten Sigma-Delta-Modulators M5. Dem Verstärker A4 folgt ebenfalls ein Sigma-Delta-Modulator, nämlich ein Sigma-Delta-Modulator M5. Beide Sigma-Delta-Modulatoren M4 und M5 sind zweiter Ordnung. Das vom jeweils zugeordneten Verstärker A4 bzw. A5 abgegebene Signal wird in den beiden Sigma-Delta-Modulatoren M4,M5 daher jeweils zweimal integriert, wobei vor jeder Integration das Ausgangssignal des jeweiligen Sigma-Delta-Modulators hinzuaddiert wird und anschließend mit einem gegebenen Schwellenwert verglichen wird. Das Ergebnis dieses Vergleichs, eines größer/kleiner Vergleichs, ist das mit einem Bit binär kodierte Ausgangssignal des jeweiligen Sigma-Delta-Modulators.

An die Sigma-Delta-Modulatoren M4,M5 ist jeweils eine erste Abtastratenreduziereinrichtung R4 bzw. R5 angeschlossen. Das digitale Ausgangssignal des Verstärkers A4 bzw. A5 wird durch die Abtastratenreduziereinrichtung R4 bzw. R5 beispielsweise zunächst dreimal integriert. Eine einzelne Integration wird dabei so ausgeführt, daß zum aktuellen Amplitudenwert eines zu integrierenden Signales der bisherige Summenwert addiert wird und als aktueller Summenwert bis zum nächsten Abtastzeitpunkt gespeichert wird. Aufgrund der Integration bzw. der mehrfachen Integration erhöht sich die Wortlänge des digitalen Signales. Im vorliegenden Ausführungsbeispiel umfaßt das Signal nun 19 Bit. Anschließend wird durch zyklisches Nullsetzen von $n_1-1$ Abtastwerten und Durchschalten des $n_1$-ten Abtastwertes die Abtastrate $f_1$ am Ausgang der Sigma-Delta-Modulatoren auf $f_1/n_1$ erniedrigt. Alle weiteren Operationen werden nun mit einer Abtastrate $f_2 = f_1/n_1$ durchgeführt. Danach wird zu dem mit einem Faktor $a_0$ multiplizierten aktuellen Signalwert, der mit einem Faktor $a_1$ multiplizierte letzte Signalwert, der mit einem Faktor $a_2$ multiplizierte vorletzte Signalwert und der mit einem Faktor $a_3$ multiplizierte drittletzte Signalwert hinzuaddiert. Schließlich wird das Signal in seiner maximalen Amplitude begrenzt. Dazu wird das Signal unverändert weitergeleitet, wenn der darstellbare Wertebereich des Signals eingehalten ist oder das Signal unter Beibehaltung des Vorzeichens auf Maximalwert gesetzt und weitergeleitet, wenn der darstellbare Wertebereich überschritten ist. Es wird so verhindert, daß bei einem Überschreiten der Aussteuerungsgrenze des Sigma-Delta-Modulators und/oder der Integrierer des darstellbaren Wertebereichs des Signals unzutreffende Signalwerte produziert werden.

Die Ausgänge der beiden Abtastratenreduziereinrichtungen R4,R5 sind mit einer Prioritätslogik PL1 verbunden. Die Prioritätslogik PL1 vergleicht den Amplitudenwert des Signales am Ausgang der Abtastratenreduziereinrichtung R4 mit einem Schwellenwert. Ein Schwellenwertvergleich kann unter anderem dadurch erfolgen, daß beispielsweise die drei höherwertigsten Bits mittels eines Dreifach-ODER-Gatters dahingehend überprüft werden, ob diese gesetzt sind und damit ein Überschreiten des dadurch festgelegten Schwellenwertes vorliegt. Ist der Amplitudenwert im stationären Fall größer als der Schwellenwert, so ist die Abtastratenreduziereinrichtung R4 zum Ausgang durchgeschaltet. Ist dieser kleiner, so ist die Abtastratenreduziereinrichtung R5 durchgeschaltet. Beim Überschreiten des Schwellenwertes schaltet die Prioritätslogik PL dabei sofort, während sie beim Unterschreiten erst nach einer gegebenen Verzögerungszeit, beispielsweise nach Ablauf einer gewissen Zahl von Abtastzeitpunkten, schaltet. Das hat den Vorteil, daß dem jeweils übersteuerten analogen Verstärker eine gewisse Erholzeit eingeräumt wird. Ein übersteuerter analoger Verstärker erreicht nämlich üblicherweise erst nach einer gewissen Zeit nach Zurücknahme der Übersteuerung wieder seinen linearen Arbeitsbetrieb.

Das vorliegende Ausführungsbeispiel zeigt explizit keine Dämpfungsglieder. Stattdessen wurde eine Dämpfungsanpassung dadurch vorgenommen, indem die Wortbreite des Signals von 18 Bit auf 20 Bit erhöht ist. Dabei werden in der Prioritätslogik PL in einem Fall die 18 Bit des Ausgangssignales der Abtastratenreduziereinrichtung RA4 zu den 18 höherwertigsten Bits des 20-Bit-Signals und die beiden niederwertigsten Bits werden gleich Null gesetzt, während im anderen Fall die 17 Bit des Ausgangssignals der Abtastratenreduziereinrichtung RA5 zu den 17 niederwertigsten Bits werden und die beiden höherwertigen Bits des 20-Bit-Signals (Bit 18 und 19) unter Beibehaltung des Vorzeichens gleich Null gesetzt werden. Das bedeutet, daß das höherwertigste Bit des 20 Bit-Signals gleich dem höherwertigsten Bit des Ausgangssignals der Abtastratenreduziereinrichtung RA5 gesetzt wird.

Der Prioritätslogik PL ist wiederum eine Abtastratenreduziereinrichtung RA nachgeschaltet. Im gezeigten Ausführungsbeispiel weist diese ein nichtrekursives Tiefpaßfilter auf, im Gegensatz zu den rekursiven Tiefpaßfiltern der Abtastreduziereinrichtungen R4 und R5. Eine Verwendung eines rekursiven Tiefpaßfilters, beispielsweise eines Wellendigitalfilters, ist jedoch ebenso möglich. Auch ist der Einsatz von nichtrekursiven Filtern bei den ersten Abtastratenreduziereinrichtungen R4 und R5 in gleicher Weise zulässig. In dem nichtrekursiven Tiefpaßfilter der Abtastratenreduziereinrichtung RA werden die unterschiedlich zeitverzögerten Eingangssignale jeweils zunächst mit Koeffizienten $b_0...b_m$ multipliziert und dann aufaddiert. Als bevorzugtes Filterverhalten wird dabei insbesondere das Verhalten eines Spalt-Tiefpasses angestrebt. Anschließend wird wiederum durch zyklisches Nullsetzen von $n_2-1$ Abtastwerten und Durchschalten des $n_2$-ten Abtastwertes die Abtastrate $f_2$ auf $f_2/n_2$ erniedrigt. Die Abtastrate $f_3$ am Ausgang A beträgt somit $f_3 = f_2/n_2$.

Weitere Ausgestaltungen einer erfindungsgemäßen Analog-Digital-Wandleranordnung ergeben sich beispielsweise durch Änderung der Schaltungsstruktur bzw. der Ordnung der Sigma-Delta-Modulatoren sowie durch Änderung der Filterstrukturen bei den einzelnen Abtastratenreduziereinrichtungen. Neben einer funktionsbezogenen Hardware-Realisierung bietet sich bei der erfindungsgemäßen Analog-Digital-Wandleranordnung aber auch der Einsatz eines oder mehrerer Signalprozessoren zur digitalen Signalverarbeitung nach den Sigma-Delta-Modulatoren an.

Erfindungsgemäße Analog-Digital-Wandleranordnungen weisen insbesondere durch die Möglichkeit der Gleitkommadarstellung der digitalen Ausgangssignale, eine hohe Auflösung und eine hohe Wandlungsgeschwindigkeit bei gleichzeitig geringem Schaltungsaufwand auf. Eine Verringerung des Schaltungsaufwandes resultiert vor allem daraus, daß die den Sigma-Delta-Modulatoren unmittelbar nachfolgenden Abtastratenreduziereinrichtungen relativ unaufwendig ausgeführt werden können, während die der Prioritätslogik nachgeschaltete Abtastreduziereinrichtung wesentlich aufwendiger und damit exakter aufgebaut werden kann bei insgesamt geringem Schaltungsaufwand, dadiese im Gegensatz zu den anderen Abtastratenreduziereinrichtungen nur einmal zu realisieren ist. Die Signalverzögerungszeit durch die Tiefpässe der ersten Abtastratenreduziereinrichtungen ist geringer, da diese aufgrund der höheren Abtastrate $f_2$ gegenüber der Abtastrate $f_3$ eine höhere Grenzfrequenz aufweisen, wodurch ein schnelleres Ansprechen der Prioritätslogik erzielt wird.

**Ansprüche**

1. Analog-Digital-Wandleranordnung mit i Sigma-Delta-Modulatoren (M0...M5), die durch ein analoges Eingangssignal (E) angesteuert werden und die digitale Ausgangssignale mit bestimmter Abtastrate ($f_1$) abgeben,
mit i Verstärkern (A1...A5), die den Sigma-Delta-Modulatoren (M0...M5) jeweils vorgeschaltet sind,
mit i ersten Abtastratenreduziereinrichtungen (R0...R5), die den Sigma-Delta-Modulatoren (M0...M5) jeweils nachgeschaltet sind,
mit i Dämpfungsgliedern (D0,D2,D3), die den Abtastratenreduziereinrichtungen (R1,R2,R3) jeweils nachgeschaltet sind und deren Dämpfungsfaktoren jeweils gleich dem Kehrwert des im Eingangskreis des entsprechenden Sigma-Delta-Modulators auftretenden Verstärkungsfaktors sind,
mit einer Prioritätslogik (PL), die nach Auswertung der Signale der Abtastratenreduziereinrichtungen (R0...R5) eines der Signale zum Ausgang (A) durchschaltet, und
mit einer zweiten Abtastratenreduziereinrichtung (RA), die der Prioritätslogik (PL) nachgeschaltet ist.
2. Analog-Digital-Wandleranordnung nach Anspruch 1, **dadurch gekennzeichnet,** daß jeweils benachbarte Sigma-Delta-Modulatoren (M0...M3) über jeweils einen der Verstärker (A1,A2,A3) miteinander verbunden sind und daß alle Verstärker (A1,A2,A3) den gleichen Verstärkungsfaktor aufweisen.
3. Analog-Digital-Wandleranordnung nach Anspruch 1,
**dadurch gekennzeichnet,**
daß den Sigma-Delta-Modulatoren (M0...M5) vorgeschaltete Verstärker (A1...A5) eingangsseitig parallelgeschaltet sind und unterschiedliche Verstärkungsfaktoren aufweisen.
4. Analog-Digital-Wandleranordnung nach Anspruch 2 oder 3,
**dadurch gekennzeichnet,**
daß die Verstärkungsfaktoren der Verstärker (A1...A5) Potenzen von 2 sind.
5. Analog-Digital-Wandler naoh einem der Ansprüche 1 bis 4,
**dadurch gekennzeichnet,**
daß die Prioritätslogik (PL) Signale der ersten Abtastratenreduziereinrichtungen (R0...R5) mit jeweils ersten Abtastratenreduziereinrichtungen (R0...R5) zugeordneten Schwellenwerten vergleicht, wobei die Prioritätslogik (PL) die erste Abtastratenreduziereinrichtung zum Ausgang (A) durchschaltet, deren Signal den Schwellenwert nicht überschreitet und deren zugeordneter Verstärker den größten Verstärkungsfaktor aufweist.
6. Analog-Digital-Wandler nach Anspruch 5,
**dadurch gekennzeichnet,**
daß die Schwellenwerte einer Aussteuerung der jeweils zugeordneten Verstärker entsprechen, die innerhalb der Aussteuergrenze des jeweiligen Verstärkers liegt.
7. Analog-Digital-Wandler nach einem der Ansprüche 1 bis 6,
**dadurch gekennzeichnet,**
daß die Prioritätslogik (PL) beim Überschreiten eines Schwellenwertes ein Umschalten von einer zur anderen Abtastratenreduziereinrichtung zum einen zeitverzögert durchführt, wenn der einen ersten Abtastratenreduziereinrichtung ein Verstärker mit höherem Verstärkungsfaktor als dem Verstärker der anderen zugeordnet ist, und zum anderen verzögerungsfrei durchführt, wenn der einen ersten Abtastratenreduziereinrichtung ein Verstärker mit niedrigerem Verstärkungsfaktor als dem Verstärker der anderen zugeordnet ist.

# FIG 1

# FIG 2

FIG 3

# EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | ICASSP 86, PROCEEDINGS, April 7-11 1986, IEEE New York, US; T. Taniguchi et al.: "A High-Efficiency Speech Coding Algorithm Based on ADPCM Multi-Quantizer"; Seiten 1721-1724; * Seite 1721, rechte Spalte, letzter Absatz - Seite 1722, linke Spalte, letzter Absatz; Figur 2 * | 1-4, 6 | H03M3/02 |
| A | IEEE JOURNAL OF SOLID-STATE CIRCUITS. vol. 23, no. 3, Juni 1988, NEW YORK US Seiten 736 - 741; J. Robert er al.: "A Second Order High-Resolution Incremental A/D Converter with Offset and Charge Injection Compensation" * Seite 736, linke Spalte, Absatz 1; Figuren 1, 2 * | 1 | |
| A | ICASSP 88, April 11-14 1988, IEEE New York, US; E. Dijkstra et al.:"On the Use of Modulo Arithmetic Comb Filters in Sigma Delta Modulators", Seiten 2001 - 2004; * "Seite 2001, linke Spalte, Absatz 1; Figur 2* | 1 | |
| D,A | DE-C-3337041 (KRAUTKRÄMER GMBH) * Spalte 4, Zeilen 2 - 20 * * Spalte 4, Zeilen 55 - 60 * * Spalte 5, Zeile 66 - Spalte 6, Zeile 14; Figuren 2, 6 * | 1-4, 6 | RECHERCHIERTE SACHGEBIETE (Int. Cl.5) H03M |

Der vorliegende Recherchenbericht wurde für alle Patentansprüche erstellt

| Recherchenort | Abschlußdatum der Recherche | Prüfer |
|---|---|---|
| DEN HAAG | 26 JULI 1990 | BLAAS D.L.A.J. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
  : nichtschriftliche Offenbarung
  : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)